Europäisches Patentamt

European Patent Office

Office européen des brevets

(19)

(11) Veröffentlichungsnummer: **0 152 889**
**B1**

(12) **EUROPÄISCHE PATENTSCHRIFT**

(45) Veröffentlichungstag der Patentschrift:
**16.09.87**

(51) Int. Cl.⁴: **G 03 C 1/68**, G 03 G 5/05

(21) Anmeldenummer: **85101429.0**

(22) Anmeldetag: **11.02.85**

(54) **Lichtempfindliche Aufzeichnungsmaterialien.**

(30) Priorität: **18.02.84 DE 3405959**

(43) Veröffentlichungstag der Anmeldung:
**28.08.85 Patentblatt 85/35**

(45) Bekanntmachung des Hinweises auf die Patenterteilung:
**16.09.87 Patentblatt 87/38**

(84) Benannte Vertragsstaaten:
**CH DE FR GB IT LI NL SE**

(56) Entgegenhaltungen:
**EP - A - 0 049 504**
**EP - A - 0 065 285**
**DE - A - 3 215 968**

(73) Patentinhaber: **BASF Aktiengesellschaft,**
**Carl-Bosch-Strasse 38, D-6700 Ludwigshafen (DE)**

(72) Erfinder: **Hoffmann, Gerhard, Dr., Pappelstrasse 22,**
**D-6701 Otterstadt (DE)**
Erfinder: **Hofmann, Reiner, Dr., Mandelbergstrasse 44,**
**D-6730 Neustadt 23 (DE)**
Erfinder: **Elzer, Albert, Dr., Pappelstrasse 4,**
**D-6701 Otterstadt (DE)**

ACTORUM AG

EP 0 152 889 B1

## Beschreibung

Die Erfindung betrifft lichtempfindliche Aufzeichnungsmaterialien, insbesondere zur Herstellung von Flachdruckplatten oder auch Resistmustern, mit einer auf einem Träger aufgebrachten, ein polymeres Bindemittel enthaltenden, wässrig entwickelbaren — insbesondere wässrig-alkalisch entwickelbaren — lichtempfindlichen Aufzeichnungsschicht.

Mit Wasser oder insbesondere wässrig-alkalischen Medien auswaschbare, lichtempfindliche Aufzeichnungsmaterialien für die Herstellung von Flachdruckplatten oder Resistmustern sind bekannt. Diese enthalten im allgemeinen auf einem dimensionsstabilen Träger, beispielsweise einem Aluminiumblech oder einer Kunststoff-Folie, eine ein polymeres Bindemittel enthaltende, lichtempfindliche Aufzeichnungsschicht. Als polymere Bindemittel gelangen hierbei insbesondere in wässrigen Medien, vorzugsweise in wässrig-alkalischen Medien, lösliche bzw. dispergierbare Copolymerisate zur Anwendung, wie z.B. Styrol/Maleinsäureanhydrid-Copolymerisate, Styrol/Maleinsäurehalbester-Copolymerisate, (Meth)acrylat/(Meth)acrylsäure-Copolymerisate oder auch Copolymerisate aus Styrol, (Meth)acrylaten und (Meth)acrylsäure sowie gegebenenfalls anderen Comonomeren.

Bei photopolymerisierbaren Aufzeichnungsmaterialien, wie sie insbesondere für die Herstellung von photopolymeren Flachdruckplatten oder Resistmustern Einsatz finden, enthält die lichtempfindliche, photopolymerisierbare Aufzeichnungsschicht neben den in wässrigen Medien löslichen bzw. dispergierbaren polymeren Bindemitteln üblicherweise mindestens eine ethylenisch ungesättigte, photopolymerisierbare, niedermolekulare Verbindung, mindestens einen Photopolymerisationsinitiator sowie gegebenenfalls weitere Zusatz- und/oder Hilfsstoffe, wie z.B. thermische Polymerisationsinhibitoren, Farbstoffe, Pigmente, sensitometrische Regler, Weichmacher, Füllstoffe usw. derartige wässrig entwickelbare, photopolymerisierbare Aufzeichnungsmaterialien sind u.a. in der DE-B-2 027 467, DE-B-2 064 080, De-A-2 205 146, DE-A-2 602 410 und EP-A-49 502 beschrieben.

Aus der EP-A-65 285 ist ein durch Strahlung polymerisierbares, zur Herstellung von Kopiermaterial verwendbares Gemisch bekannt, das als wesentliche Bestandteile ein wasserunlösliches, in wässrigalkalischen Lösungen lösliches oder mindestens quellbares Bindemittel, einen durch Strahlung aktivierbaren Polymerisationsinitiator und ein polyglykoldi(meth)acrylat enthält.

Bei wässrig entwickelbaren, elektrophotographischen Aufzeichnungsmaterialien ist auf einem elektrisch leitenden Schichtträger eine lichtempfindliche, photoleitfähige Aufzeichnungsschicht aufgebracht, die neben dem in wässrigen Medien löslichen bzw. dispergierbaren polymeren Bindemittel mindestens eine Ladungsträger erzeugende Verbindung bzw. einen Sensibilisator und mindestens eine Ladungsträger transportierende Verbindung sowie gegebenenfalls weitere Zusatzstoffe enthält. Zum Stand der Technik sei hierzu beispielsweise auf die DE-B-1 117 391, die EP-B-4944 sowie die DE-A-3 215 968 verwiesen.

Diese bekannten, lichtempfindlichen Aufzeichnungsmaterialien der in Rede stehenden Art lassen hinsichtlich einer Reihe ihrer Eigenschaften noch zu wünschen übrig. So sind häufig gerade für Offset-Schichten, die üblicherweise unter 2 µm dick sind, die Filmbildungseigenschaften der lichtempfindlichen Aufzeichnungsschicht nicht hinreichend, oder aber die Aufzeichnungsschicht ist zu spröde oder weist eine zu geringe Abriebfestigkeit auf. Versucht man diese Nachteile beispielsweise durch Erhöhung des Molekulargewichts der polymeren Bindemittel auszugleichen, werden andere vorteilhafte Eigenschaften der Aufzeichnungsmaterialien, insbesondere die Entwicklungszeiten, beeinträchtigt. In der DE-B-2 718 047 werden photopolymerisierbare, mit Wasser entwickelbare Gemische zur Herstellung von Flachdruckplatten oder Photoresistschichten beschrieben, die als Bindemittel ein relativ hochmolekulares, wasserlöslichen Methacrylsäurepolymerisat mit mindestens 70% Methacrylsäure-Einheiten enthalten. Damit ist es möglich, die Entwicklung der mit diesen photopolymerisierbaren Gemischen hergestellten Aufzeichnungsmaterialien mit Wasser alleine vorzunehmen, jedoch lassen auch diese Aufzeichnungsmaterialien hinsichtlich ihres Gesamteigenschaftsbildes sowie insbesondere der notwendigen, relativ langen Entwicklungszeiten zu wünschen übrig.

Der vorliegenden Erfindung lag die Aufgabe zugrunde, neue wässrig-entwickelbare, lichtempfindliche Aufzeichnungsmaterialien, insbesondere für die Herstellung von Flachdruckplatten oder Resistmustern, aufzuzeigen, die sich durch eine ausgewogene vorteilhafte Eigenschaftskombination auszeichnen. Insbesondere war es Aufgabe der vorliegenden Erfindung, solche wässrig entwickelbaren, lichtempfindlichen Aufzeichnungsmaterialien zu schaffen, deren lichtempfindliche Aufzeichnungsschicht sich sowohl vor als auch nach der Entwicklung durch gute mechanische Eigenschaften auszeichnet und die gleichzeitig ein sehr gutes Auswaschverhalten zeigen, ohne dass ihr allgemeines Eigenschaftsprofil negativ verändert wird.

Es wurde nun gefunden, dass diese Aufgabe durch lichtempfindliche Aufzeichnungsmaterialien gelöst wird, die in ihrer lichtempfindlichen Aufzeichnungsschicht als polymeres Bindemittels ein in wässrigen Medien lösliches oder zumindest dispergierbares Copolymerisat enthalten, welches einen geringen Anteil des Anhydrids einer polymerisierbaren, mindestens eine ethylenische Unsättigung enthaltenden Moncarbonsäure als Comonomeres eingebaut enthält.

Gegenstand der Erfindung ist dementsprechend ein lichtempfindliches Aufzeichnungsmaterial, insbesondere für die Herstellung von Flachdruckplatten oder Resistmustern, mit einer ein in wässrigen Medien — insbesondere wässrig-alkalischen Medien — lösliches oder zumindest dispergierbares polymeres Bindemittel enthaltenden, wässrig entwickelbaren — insbesondere wässrig-alkalisch entwickelbaren — lichtempfindlichen Aufzeichnungsschicht, welches dadurch gekennzeichnet ist, dass in der lichtempfindlichen Aufzeichnungsschicht als polymeres Bindemittel ein Copolymerisat enthalten ist, welches ein Anhydrid einer polymerisierbaren, ethylenisch ungesättigten Monocarbonsäure in einer Menge von 0,05 bis 2 Gew.-%, vorzugsweise in einer Menge von 0,1 bis 1 Gew.-%, bezogen auf das Copolymerisat, als Comonomeres einpolymerisiert enthält.

Unter lichtempfindlichen Aufzeichnungsmaterialien werden im Rahmen dieser Erfindung dabei sowohl die Aufzeichnungsmaterialien mit einer lichtempfindlichen, photopolymerisierbaren Aufzeichnungsschicht als auch die Aufzeichnungsmaterialien mit einer lichtempfindlichen, elektrophotographischen Aufzeichnungsschicht verstanden, wie sie z.B. in den eingangs zitierten Druckschriften beschrieben sind.

Bei den erfindungsgemäss in den lichtempfindlichen Aufzeichnungsschichten dieser Aufzeichnungsmaterialien enthaltenen polymeren Bindemitteln handelt es sich um in wässrigen Medien, insbesondere in wässrig-alkalischen Medien, lösliche bzw. dispergierbare Copolymerisate. Zum Aufbau dieser Cpolymerisate kommen grundsätzlich die hierfür in der Literatur beschriebenen Comonomeren in Betracht. Insbesondere handelt es sich hierbei um Copolymerisate von einem oder mehreren Vinyl-Monomeren, die als solche wasserunlösliche Polymerisate bilden, mit einem oder mehreren Monomeren mit freien Säure-Gruppen, insbesondere Sulfonsäure- oder Carboxyl-Gruppen, oder mit cyclischen Anhydrid-Gruppierungen, insbesondere cyclischen Anhydriden von ethylenisch ungesättigten Dicarbonsäuren. Als Beispiel für die Vinyl-Monomeren seien genannt: Vinylaromaten, wie z.B. Styrol, substituierte Styrole, die in der Seitenkette oder im Kern beispielsweise durch Alkylgruppen oder Halogenatome substituiert sind, wie α-Methylstyrol, o- oder p-Chlorstyrol, Vinyltolul und dergleichen; Ester und Amide der Acrylsäure oder Methacrylsäure, wie z.B. Acrylate oder Methacrylate von Alkanolen mit 1 bis 20 C-Atomen, wie Methyl(meth)acrylat, Ethyl(meth)acrylat, Butyl(meth)acrylat, Hexyl(meth)-acrylat, Hydroxyalkyl(meth)acrylate, insbesondere mit 2 bis 6 C-Atomen im Hydroxyalkyl-Rest, Glycidyl(meth)acrylat, (Meth)acrylamid und Derivate hiervon und dergleichen; (Meth)acrylnitril; Vinylacetat, Vinylpropionat; Vinylchlorid; Vinylalkylketone, insbesondere mit 1 bis 4 Kohlenstoffatomen im Alkylrest; Vinylalkylether, insbesondere mit 1 bis 8 C-Atomen im Alkylrest. Bei der zweiten Gruppe der Comonomeren mit den sauren Gruppen, wie beispielsweise Sulfonsäure- oder freien Carboxylgruppen, oder cyclischen Anhydrid-Gruppierungen, sind insbesondere beispielhaft zu nennen: Acrylsäure, Methacrylsäure, Crotonsäure, Maleinsäure, Fumarsäure, Maleinsäurehalbester, Maleinsäureanhydrid. Als weitere Comonomere für die erfindungsgemäss einzusetzenden Copolymerisate kommen auch N-Vinyllactame, wie insbesondere N-Vinylpyrrolidon und N-Vinylcaprolactam, in Frage.

Erfindungdgemäss enthalten die als Bindemittel einzusetzenden Copolymerisate ferner 0,05 bis 2 Gew.-%, bezogen auf das Copolymerisat, eines Anhydrides einer polymerisierbaren, ethylenische Unsättigungen enthaltenden Monocarbonsäure als weiteres Comonomer mit einpolymerisiert. Liegt der Anteil an diesen Comonomeren in dem Copolymerisat unter 0,05 Gew.-%, so ist kein nennenswerter Einfluss auf die Eigenschaften der lichtempfindlichen Aufzeichnungsschicht festzustellen. Übersteigt der Gehalt an diesen Comonomeren im Copolymerisat 2 Gew.-%, so sind die Cpolymerisate für den Einsatz in lichtempfindlichen Aufzeichnungsschichten in aller Regel nicht mehr geeignet. Optimale Ergenbisse wurden mit solchen Cpolymerisaten erzielt, die 0,1 bis 1 Gew.-% und insbesondere 0,2 bis 0,6 Gew.-%, bezogen auf das Copolymerisat, des Anhydrides einer polymerisierbaren, ethylenisch ungesättigten Monocarbonsäure einpolymerisiert enthielten. Unter den Anhydriden von polymerisierbaren ethylenisch ungesättigten Monocarbonsäuren sind insbesondere Acrylsäureanhydrid sowie Methacrylsäureanhydrid zu nennen. Weiterhin gehören hierzu auch beispielsweise Crotonsäureanhydrid, Dimethylacrylsäureanhydrid, sowie Anhydride von Hydroxycarbonsäuren, z.B. Glykolsäure, oder Aminocarbonsäuren, beispielsweise Glycin, deren Hydroxy- bzw. Amino-Gruppen mit geeigneten, polymerisierbaren, ethylenisch ungesättigten Verbindungen, z.B. (Meth)acrylsäure oder (Meth)acrylamid umgesetzt worden sind. Zu der letztgenannten Gruppe der Comonomeren gehören beispielsweise (Meth)acrylamidoglykolsäureanhydrid und Glykolsäureanhydriddi(meth)acrylat.

Bevorzugt als polymere Bindemittel für die lichtempfindlichen Aufzeichnungsmaterialien sind dabei solche in wässrigen Medien, insbesondere wässrig-alkalischen Medien, löslichen bzw. dispergierbaren Copolymerisate, die neben dem erfindungsgemässen Anteil des Anhydrides einer ethylenisch ungesättigten Monocarbonsäure als Comonomere mindestens eins, vorzugsweise aber zwei oder mehr Monomere aus der Gruppe Styrol, Alkyl(meth)acrylate, (Meth)acrylamid, Hydroxyalkyl(meth)acrylate, Vinylacetat, N-Vinylpyrrolidon, (Meth)acrylsäure, Maleinsäureanhydrid und Maleinsäurehalbester einpolymerisiert enthalten. Sehr geeignet sind z.B. Copolymerisate, die neben dem erfindungsgemässen Anteil des Anhydrides einer ethylenisch ungesättigten Monocarbonsäure sowie gegebenenfalls weiteren Comonomerbausteinen folgende Comonomere einpolymerisiert enthalten: Styrol und Maleinsäureanhydrid; Styrol und Maleinsäurehalbester; Styrol, Maleinsäureanhydrid und Maleinsäurehalbester; Styrol, Maleinsäureanhydrid und Acrylsäure und/oder vorzugsweise Methacrylsäure; (Meth)acrylsäureester und Acrylsäure und/oder vorzugsweise Methacrylsäure; Styrol, (Meth)acrylsäureester, und Acrylsäure und/oder vorzugsweise Methacrylsäure. Als Anhydrid einer ethylenisch ungesättigten Monocarbonsäure sind dabei in allen Fällen Acrylsäureanhydrid, Methacrylsäureanhydrid oder Crotonsäureanhydrid bevorzugt. Als besonders günstig haben sich solche Copolymerisate erwiesen, die 5 bis 70 Gew.-% Styrol, 5 bis 50 Gew.-% Acrylsäure und/oder vorzugsweise Methacrylsäure, 5 bis 50 Gew.-% Maleinsäureanhydrid, 0,05 bis 2 Gew.-% Acrylsäureanhydrid bzw. vorzugsweise Methacrylsäureanhydrid und 0 bis 30 Gew.-% an anderen Comonomeren, wie z.B.

Vinylacetat, (Meth)acrylsäureester oder dergleichen, einpolymerisiert enthalten, wobei die Prozentangaben jeweils auf das Gewicht des Copolymerisats bezogen sind. Ebenfalls sehr geeignet sind Copolymerisate aus 5 bis 70 Gew.-% Styrol, 5 bis 50 Gew.-% Alkyl(meth)acrylaten, 5 bis 50 Gew.-% Acrylsäure und/oder vorzugsweise Methacrylsäure, 0,05 bis 2 Gew.-% (Meth)acrylsäureanhydrid und 0 bis 30 Gew.-% an anderen Comonomeren, insbesondere Hydroxyalkyl(meth)acrylaten oder dergleichen.

Die erfindungsgemäss als polymeres Bindemittel einzusetzenden Copolymerisate unterscheiden sich in ihrer Zusammensetzung von den bekannten polymeren Bindemitteln dieser Art im wesentlichen nur durch den Einbau einer geringen Menge eines Anhydrides einer ethylenische Unsättigungen enthaltenden, polymerisiertbaren Monocarbonsäure und damit verbunden durch ein vergleichsweise höheres Molekulargewicht. Die mit den erfindungsgemässen Copolymerisaten als Bindemittel hergestellten lichtempfindlichen Aufzeichnungsschichten zeichnen sich gegenüber den bekannten Materialien durch verbesserte mechanische Eigenschaften aus, ohne dass die Entwicklungszeiten oder sonstige Eigenschaften beeinträchtigt werden. Während man bisher zur Beibehaltung einer guten Entwicklungsfähigkeit relativ niedermolekulare Bindemittel wählen musste, ist es mit den erfindungsgemässen Copolymerisaten möglich, trotz des wesentlich höheren Molekulargewichtes gleich kurze Entwicklungszeiten wie bisher bei den vergleichsweise niedermolekularen polymeren Bindemitteln einzuhalten. Dabei kommen erfindungsgemäss gleichzeitig die vorteilhaften Eigenschaften von hochmolekularen Bindemitteln in den Aufzeichnungsschichten zum Tragen.

Die erfindungsgemäss einzusetzenden Copolymerisate können nach den an sich bekannten und üblichen Polymerisationsmethoden durch Copolymerisation der Comonomeren hergestellt werden. Die Copolymerisation kann dabei beispielsweise nach der Lösungs- oder der Fällungspolymerisationsmethode durchgeführt werden. Für eine Lösungspolymerisation eignen sich z.B. Tetrahydrofuran, Dimethoxyethan, Dioxan oder Essigester als Lösungsmittel, wobei die Konzentration der Monomeren insgesamt bevorzugt zwischen 25 und 45 Gew.-%, bezogen auf die Lösung, liegen sollte. Für eine Fällungspolymerisation eignen sich aliphatische oder aromatische Kohlenwasserstoffe als indifferente Lösungsmittel; hierbei wird die Konzentration der Monomeren im allgemeinen zwischen 5 und 25 Gew.-% eingestellt. Als Polymerisationsinitiatoren kommen die üblichen radikalischen Starter, wie beispielsweise Azobisisobutyronitril, in Betracht. Die Polymerisationstemperatur liegt im allgemeinen zwischen 50 und 100°C, vorzugsweise zwischen 75 und 95°C.

Die Wahl des Copolymerisats hängt im wesentlichen von der weiteren Zusammensetzung der lichtempfindlichen Aufzeichnungsschicht und deren gewünschten anwendungstechnischen Eigenschaften ab. Sie kann grundsätzlich nach den gleichen oder ähnlichen Kriterien erfolgen, wie bei den bekannten Materialien der in Rede stehenden Art und ist somit für den Fachmann, gegebenenfalls anhand weniger, einfacher Vorversuche, ohne weiteres und leicht festzulegen. Bei den elektrophotographischen Aufzeichnungsmaterialien lassen sich die als Bindemittel einzusetzenden Copolymerisate leicht an die in den photoleitfähigen Aufzeichnungsschichten enthaltenen Ladungsträger transportierenden Verbindungen anpassen.

Lichtempfindliche Aufzeichnungsmaterialien mit einer lichtempfindlichen, photopolymerisierbaren Aufzeichnungsschicht enthalten dabei in dieser Schicht neben den erfindungsgemässen polymeren Bindemitteln im allgemeinen mindestens eine ethylenisch ungesättigte, photopolymerisierbare, niedermolekulare Verbindung, wenigstens einen Photopolymerisationsinitiator bzw. ein Photopolymerisationsinitiatorsystem sowie gegebenenfalls weitere Zusatz- und/oder Hilfsstoffe zur Verbesserung und/oder Modifizierung der allgemeinen Eigenschaften der Aufzeichnungsschichten bzw. der hieraus hergestellten Flachdruckformen oder Resistmuster. In einer typischen Ausführungsform enthalten solche lichtempfindlichen, photopolymerisierbaren Aufzeichnungsschichten beispielsweise 40 bis 90 Gew.-% des erfindungsgemässen Bindemittels, 5 bis 50 Gew.-% an ethylenisch ungesättigten, photopolymerisierbaren, niedermolekularen Verbindungen, 0,5 bis 10 Gew.-% wenigstens eines Photoinitiators oder Photoinitiator-Systems, 0 bis 8 Gew.-%, vorzugsweise 0,01 bis 5 Gew.-%, an die Belichtungs- und/oder Polymerisationseigenschaften beeinflussenden Hilfsmitteln, wie z.B. Farbstoffen, sensitometrischen Reglern, thermischen Polymerisationsinhibitoren usw., und 0 bis 20 Gew.-% an die mechanischen Eigenschaften verbessernden oder modifizierenden Zusatzstoffen, wie beispielsweise Weichmachern, Füllstoffen, Verlaufshilfsmitteln, weiteren, indifferenten, hoch- oder niedermolekularen Polymeren usw., wobei sich die Prozentangaben stets auf die gesamte Aufzeichnungsschicht beziehen. Für die neben den erfindungsgemässen polymeren Bindemitteln in den lichtempfindlichen, photopolymerisierbaren Aufzeichnungsschichten vorliegen weiteren Bestandteile kommen die hierfür üblichen und an sich bekannten Verbindungen und Stoffe in Betracht, wie sie u.a. in der eingangs zitierten Literatur beschrieben sind.

Als ethylenisch ungesättigte, photopolymerisierbare niedermolekulare Verbindungen kommen sowohl Monomere als auch Oligomere (mit einem Molekulargewicht bis etwa 5000, insbesondere mit einem Molekulargewicht bis etwa 3000) in Betracht, wobei diese sowohl mono- oder auch mehrfunktionell sein können, d.h. eine oder mehrere photopolymerisierbare, ethylenische Doppelbindungen besitzen können. Üblicherweise sind in der lichtempfindlichen, photopolymerisierbaren Aufzeichnungsschicht bi- oder mehrfunktionelle ethylenisch ungesättigte, photopolymerisierbare, niedermolekulare Verbindungen allein oder Mischungen hiervon mit monofunktionellen ethylenisch ungesättigten, photopolymerisierbaren, niederemolekularen Verbindungen enthalten. Als Vertreter für ethylenisch ungesättigte, photopolymerisierbare, niedermolekulare Verbindungen, die allein oder in Mischung miteinander eingesetzt werden können, seien neben den Allyl- und Vinyl-Verbindungen insbesondere die Derivate der (Meth)acrylsäure und ganz besonders die (Meth)acrylsäureester genannt. Beispiele für sehr geeignete ethylenisch ungesättigte, photopolymerisierbare, niedermolekulare Verbindungen sind die Di- und Tri-(meth)acrylate von Ethylenglykol, Diethylenglykol, Triethylenglykol oder Polyethylenglykolen mit einem Molekulargewicht bis etwa 500, 1,2-Propandiol, 1,3-Propandiol, 1,4-Butandiol, 1,1,1-Trimethylolpropan, Neopentylglykol (2,2-Dimethylpropandiol), Glycerin oder Pentaerythrit; Glukosetri- oder -tetra-(meth)acrylat; ferner die Monoacrylate und Monomethacrylate der genannten Diole und Polyole, wie z.B. Ethylenglykol-, Di-, Tri- oder Tetraethylenglykolmono(meth)acrylat und die (Meth)acrylate von Monoalkanolen, insbesondere mit 1 bis 20 C-Atomen; weiterhin Monomere mit 2 oder mehr ethylenisch ungesättigten Bindungen, die Urethangruppen und/oder Amidgruppen enthalten, wie z.B. die aus aliphatischen Diolen der vorstehend genannten Art, organischen Diisocyanaten und Hydroxyalkyl-(meth)acrylaten hergestellten Urethan-(meth)acrylate. Genannt seien auch Verbindungen wie z.B. N-Vinylpyrrolidon, N-Vinylcaprolactam, Vinylacetat oder -propionat, (Meth)acrylamid, N-Methylol(meth)acrylamid, der Bisether des Ethylenglykols und N-methylol-(meth)acrylamids, Vinylcarbamate, Bisacrylamidoessigsäure, Glyoxalbisacrylamid und andere. Die ethylenisch ungesättigten, photopolymerisierbaren, niedermolekularen Verbindungen werden dabei so gewählt, dass sie mit dem eingesetzten polymeren Bindemittel verträglich sind.

Als Photoinitiator für die lichtempfindlichen, photopolymerisierbaren Aufzeichnungsschichten kommen insbesondere die für die Herstellung von Offset-Druckplatten oder Resistschichten bekannten Photoinitiatoren bzw. Photoinitiatorsysteme in Betracht. Als Beispiel für geeignete Photoinitiatoren seien neben Verbindungen wie Benzoin, den Benzoinderivaten, wie Benzoinethern, den substituierten Benzoinen, substituierten Benzoinderivaten, z.B. substituierten Benzoinethern, den Benzilen, insbesondere Benzilketalen, oder den Acylphosphinoxid-Verbindungen insbesondere Verbindungen vom Typ des Benzophenons und seiner Derivate, wie Benzophenon, 4,4'-Dimethylaminobenzophenon, 4,4'-Diethylaminobenzophenon, Derivate von Michlers Keton, 4,4'-Dichlorbenzophenon usw. und deren Gemische; Anthrachinone, wie 2-Ethylanthrachinon, t-Butylanthrachinon usw.; Bisimidazolderivate, wie 2,4,5-Triarylimidazoldimere; 2-Chlorthioxanthon, und die als Photoinitiatoren wirksamen Acridin- oder Phenazin-Derivate genannt. Beispiele für Initiatorsysteme sind Kombinationen der genannten Initiatoren mit Sensibilisierungshilfsmitteln, wie insbesondere tertiären Aminen. Typische Beispiele für solche Initiatorsysteme sind Kombinationen aus Benzophenon oder Benzophenon-Derivaten mit tertiären Aminen, wie Triethanolamin oder Michlers Keton; oder Gemische aus 2,4,5-Triarylimidazol-dimeren und 2-Mercaptobenzochinazol, Leukokristallviolett, Tris-(4-diethylamino-2-methylphenyl)-methan und ähnlichen. Die Auswahl der geeigneten Photoinitiatoren bzw. Photoinitiator-Systeme ist dem Fachmann geläufig.

Als weitere Zusatz- und/oder Hilfsstoffe für die lichtempfindlichen, photopolymerisierbaren Aufzeichnungsschichten kommen zum einen Farbstoffe und/oder Pigmente in Betracht, die sowohl als Kontrastmittel als auch schichtverfestigend wirken können. Zu den geeigneten Farbstoffen, wie sie unter anderem in den US-Patentschriften 3 218 167 und 3 884 693 beschrieben sind, gehören beispielsweise Victoria-Reinblau FGA, Victoria-Reinblau BO (C.I. 42 959), Malachitgrün, Kristallviolett, Victoria-Blau B (C.I. 44 045), Rhodamin-6 GDN (C.I. 45 160) und andere, sowie auch die Leukobasen der Triarylmethan-Farbstoffe, wie z.B. Malachitgrün-Leukobase, Kristallviolett-Leukobase, oder auch Rhodamin B-Base. Zu den weiteren Zusatz- und/oder Hilfsstoffen gehören auch die thermischen Polymerisationsinhibitoren, wie z.B. Hydrochinon, Hydrochinon-Derivate, 2,6-Di-t.-butyl-p-kresol, Nitrophenole, N-Nitrosoamine, wie N-Nitrosodiphenylamin oder die Salze des N-Nitrosocyclohexylhydroxylamins. Weiterhin können in den lichtempfindlichen, photopolymerisierbaren Aufzeichnungsschichten beispielsweise die in der Literatur beschriebenen sensitometrischen Regler enthalten sein, wie z.B. 9-Nitroanthracen, 10,10'-Bis-anthrone, Phenazinium-, Phenoxazinium-, Acridinium- oder Phenothiazinium-Farbstoffe, 1,3-Dinitrobenzole und ähnliche. Als Zusatz- und/oder Hilfsstoffe kommen z.B. auch Füllstoffe, Verstärkungsmittel, weitere, die mechanischen Eigenschaften verbessernde Bindemittel, Weichmacher, Verlaufshilfsmittel und dergleichen in Betracht.

Die lichtempfindlichen, photopolymerisierbaren Aufzeichnungsschichten lassen sich nach den an sich bekannten Methoden herstellen; sie werden mit Vorteil aus einer möglichst homogenen Lösung in einem geeigneten organischen Lösungsmittel auf das jeweilige Trägermaterial so aufgebracht, dass nach dem Ablüften des Lösungsmittels eine Trockenschichtdicke von ca. 0,1 bis 50 μm resultiert. Die Trockenschichtdicke hängt dabei im wesentlichen von dem Anwendungszweck der lichtempfindlichen Aufzeichnungsmaterialien ab und liegt für die Herstellung von Flachdruckplatten insbesondere im Bereich von 0,7 bis 3,5 μm. Für die Herstellung von Resistmustern können sowohl sehr dünne Schichten Einsatz finden, als auch dickere Resistschichten, beispielsweise im Bereich von etwa 5 bis 50 μm.

Bei den lichtempfindlichen, elektrophotographischen Aufzeichnungsmaterialien mit einer lichtempfindlichen, photoleitfähigen Aufzeichnungsschicht enthält diese neben den erfindungsgemässen Bindemitteln in homogener Verteilung mindestens eine Ladungsträger transportierende Verbindung, mindestens eine bei aktinischer Belichtung Ladungsträger erzeugende Verbindung bzw. einen Sensibilisator sowie gegebenenfalls weitere indifferente, die anwendungstechnischen sowie insbesondere die mechanischen Eigenschaften verbessernde oder modifizierende Zusatz- und/oder Hilfsstoffe. In einer gebräuchlichen, vorteilhaften Ausführungsform enthält die lichtempfindliche, photoleitfähige Aufzeichnungsschicht beispielsweise 45 bis 75 Gew.-% des erfindungsgemässen Bindemittels, 25 bis 50 Gew.-% der Ladungsträger transportierenden Verbindungen, 0,05 bis 2 Gew.-% der Ladungsträger erzeugenden Verbindungen bzw. der Sensibilisatoren sowie 0 bis 25 Gew.-% an weiteren, üblichen, insbesondere die mechanischen Eigenschaften der Aufzeichnungsschicht verbessernden und/oder modifizierenden Zusatz- und/oder Hilfsstoffen, wobei sich die Prozentangaben jeweils auf die gesamte lichtempfindliche, photoleitfähige Aufzeichnungsschicht beziehen. Sind weitere Zusatz- und/oder Hilfsstoffe in dieser enthalten, so beträgt ihr Anteil im allgemeinen mindestens 2 Gew.-%, bezogen auf die Aufzeichnungsschicht. Für die neben den erfindungsgemässen polymeren Bindemitteln in den lichtempfindlichen, photoleitfähigen Aufzeichnungsschichten enthaltenen Bestandteile kommen die für elektrophotographische Aufzeichnungsmaterialien mit einschichtigen, photoleitfähigen Aufzeichnungsschichten bekannten und üblichen Verbindungen und Stoffe in Betracht, wie sie unter anderem in der eingangs zitierten Literatur beschrieben sind.

Als Ladungsträger des elektrischen Stroms transportierende Verbindungen kommen sowohl niedermolekulare als auch polymere aromatische wie heterocyclische Verbindungen in Frage. Erwähnt seien Oxazolderivate, (DE-B-1 120 875), Oxdiazolderivate (DE-B-1 058 836), Triazolderivate (DE-B-1 060 260), Azomethine (US-A-3 041 165), Pyrazolinderivate (DE-B-1 060 714) und Imidazolderivate (DE-B-1 106 599). Als sehr vorteilhaft haben sich Benztriazol-Derivate erwiesen, insbesondere 2-(4'-Aminophenyl)-benztriazole-1,2,3, wie sie z.B. in der DE-A-3 215 968 oder der DE-A-3 324 641 beschrieben sind. Ebenso sehr gute Ergebnisse liefern auch Hydrazon-Derivate, wie sie z.B. in der DE-A-3 201 202 angeführt sind. Als polymere Ladungstransport-Verbindungen kommen neben vinylaromatischen Polymeren wie beispielsweise Polyvinylanthracen, insbesondere Poly(N-vinylcarbazol) und Mischpolymerisate des N-Vinylcarbazols mit einem überwiegenden Gehalt an N-Vinylcarbazol in Betracht. Die Ladungsträger des elektrischen Stroms transportierenden Verbindungen sollen im allgemeinen mit dem polymeren Bindemittel der lichtempfindlichen, photoleitfähigen Aufzeichnungsschicht in der erforderlichen Menge gut verträglich sein.

Als Ladungsträger erzeugende Verbindungen bzw. Sensibilisatoren für die erfindungsgemässen lichtempfindlichen, einschichtigen photoleitfähigen Aufzeichnungsschichten kommen insbesondere die an sich üblichen und bekannten Sensibilisierungsfarbstoffe in Betracht, wie z.B. Farbstoffe aus der Triarylmethanreihe, Xanthenfarbstoffe und Cyaninfarbstoffe. Sehr gute Ergebnisse wurden mit Rhodamin B (C.I. 45 170), Rhodamin 6 G, (C.I. 45 160), Malachitgrün (C.I. Basic Green 4; C.I. 42 000), Methylviolett (C.I. 42 535), Kristallviolett (C.I. 42 555), Astrazonorange R (C.I. 48 040), C.I. Basic Red 12 (C.I. 48 070), C.I. Fanal Violet 3 R supra oder Astragelb R (C.I. Basic Yellow 44) erzielt. Die Sensibilisierungsfarbstoffe können allein oder in Mischung miteinander eingesetzt werden, wobei es zur Erzielung einer panchromatischen Sensibilisierung vorteilhaft sein kann, Mischungen aus Sensibilisierungsfarbstoffen einzusetzen, die in unterschiedlichen Wellenlängenbereichen des aktinischen Lichtes absorbieren, beispielsweise Mischungen aus Triarylmethan-Farbstoffen und Cyanin-Farbstoffen.

Ferner kann die lichtempfindliche, photoleitfähige Aufzeichnungsschicht der elektrophotographischen Aufzeichnungsmaterialien für die jeweilige Verwendung übliche Zusätze enthalten, z.B. Verlaufsmittel, Weichmacher und weitere hoch- oder auch niedermolekulare Polymere.

Zur Herstellung der lichtempfindlichen, photoleitfähigen Aufzeichnungsschichten können die üblichen und an sich bekannten Methoden angewandt werden; mit Vorteil werden sie aus einer ca. 5 gew.-%igen Lösung in einem geeigneten Lösungsmittel auf das jeweilige Trägermaterial so aufgebracht, dass nach dem Ablüften des Lösungsmittels eine Trockenschichtdicke von ca. 0,1 bis 50 µm (je nach Verwendungszweck, für elektrographische Druckformen, insbesondere Flachdruckplatten, vorzugsweise ca. 1 bis 6 µm) resultiert.

Als Träger für die lichtempfindlichen Aufzeichnungsschichten kommen die für lichtempfindliche Aufzeichnungsmaterialien der in Rede stehenden Art üblichen und an sich bekannten dimensionsstabilen, starren oder vorzugsweise flexiblen Schichtträger in Betracht, wobei die Art des Schichtträgers auch vom Verwendungszweck mit bestimmt wird. So werden für Trockenfilmresiste, die insbesondere auf Basis von lichtempfindlichen photopolymerisierbaren Aufzeichnungsschichten aufgebaut sind, als Träger, vorzugsweise Kunststoff-Folien, z.B. Polyesterfolien, verwendet. Für lichtempfindliche elektrophotographische Aufzeichnungsmaterialien können als Träger prinzipiell alle elektrisch leitfähigen Trägermaterialien verwendet werden, soweit sie für das jeweilige Anwendungsgebiet geeignet sind. Bevorzugt sind für die erfindungsgemässen lichtempfindlichen Aufzeichnungsmaterialien metallische Schichtträger, z.B. aus Aluminium-, Magnesium-, Zink-, Kupfer- oder Mehrmetallplatten, die als solche oder in mechanisch, chemisch, elektrochemisch und/oder durch Versehen mit einem Haftlack vorbehandelter Form eingesetzt werden können. Geeignet als Träger sind auch Polymerfilme mit metallisierter Oberfläche, wie Aluminium-bedampfte Polyethylenterephthalat-Filme, oder auch elektrisch leitende Spezialpapiere. Für die Anwendung der erfindungsgemässen lichtempfindlichen Aufzeichnungsmaterialien bei der Herstellung von Druckformen, insbesondere Flachdruckformen, werden als Schichtträger bevorzugt Aluminiumbleche oder -folien eingesetzt, die zweckmässigerweise mechanisch oder elektrochemisch oberflächlich aufgerauht und gegebenenfalls anschliessend anodisiert worden sind. Träger für Druckformen haben dabei vorteilhafterweise eine Dicke von ca. 0,08 bis 0,3 mm.

Zwischen dem Träger und der lichtempfindlichen Aufzeichnungsschicht kann eine weitere Schicht, beispielsweise mit einer Dicke von etwa 0,03 bis 5 µm, zur Verbesserung der Haftung und/oder auch z.B. der elektrophotographischen Eigenschaften angeordnet werden. Ebenso kann auch, insbesondere bei den lichtempfindlichen, photopolymerisierbaren Aufzeichnungsmaterialien, auf der lichtempfindlichen Aufzeichnungsschicht noch eine Deckschicht oder Deckfolie angeordnet sein, die vorzugsweise in dem gleichen Entwickler-Lösungsmittel löslich ist, wie die lichtempfindliche Aufzeichnungsschicht, oder von dieser vor der Entwicklung abziehbar ist. Diese Deckschicht bzw. Deckfolie dient vor allem dem Schutz der lichtempfindlichen Aufzeichnungsschicht bei der Lagerung und Handhabung der lichtempfindlichen Aufzeichnungsmaterialien und auch als Sauerstoffsperre für die lichtempfindlichen photopolymerisierbaren Aufzeichnungsschichten. Als besonders geeignet haben sich z.B. Deckschichten aus Polyvinylalkoholen oder Polyvinylakohol-Derivaten oder Deckfolien aus Polyolefinen, wie z.B. Polyethylen, erwiesen.

Die erfindungsgemässen lichtempfindlichen Aufzeichnungsmaterialien eignen sich vorteilhaft für die Herstellung von Flachdruckformen oder Resistmustern nach den hierfür an sich bekannten und üblichen Verfahren.

Bei den lichtempfindlichen Aufzeichnungsmaterialien mit einer lichtempfindlichen photopolymerisierbaren Aufzeichnungsschicht wird hierzu zunächst die Aufzeichnungsschicht bildmässig mit aktinischem Licht belichtet, wobei sich hierfür die üblichen Lichtquellen von aktinischem Licht, wie beispielsweise UV-Fluoreszenzröhren, Quecksilberhoch-, -mittel- oder -niederdruckstrahler, superaktinische Leuchtstoffröhren, Xenon-Impulslampen, aber auch UV-Laser, Argonlaser und ähnliche, eignen. Die von den Lichtquellen emittierte Wellenlänge soll im allgemeinen zwischen 230 und 450 nm, bevorzugt zwischen 300 und 420 nm, liegen und insbesondere auf die Eigenabsorption des in der lichtempfindlichen Aufzeichnungsschicht enthaltenen Photoinitiators abgestimmt sein. Durch die bildmässige Belichtung mit aktinischem Licht wird in den belichteten Bereichen der Aufzeichnungsschicht eine Photopolymerisation ausgelöst, die zu einer Vernetzung und damit Löslichkeitsdifferenzierung zwischen den belichteten und unbelichteten Schichtbereichen führt. Nach der bildmässigen Belichtung wird die Flachdruckform bzw. das Resistmuster durch Auswaschen der unbelichteten, unvernetzten Bereiche der Aufzeichnungsschicht mit einem geeigneten Entwicklerlösungsmittel entwickelt.

Die Herstellung von Flachdruckformen mittels der erfindungsgemässen lichtempfindlichen, elektrophotographischen Aufzeichnungsmaterialien erfolgt wie üblich durch eine elektrostatische Aufladung des elektrophotographischen Aufzeichnungsmaterials mittels einer Hochspannungscorona, eine direkt nachfolgende bildmässige Belichtung der photoleitfähigen Aufzeichnungsschicht mit aktinischem Licht, die Entwicklung des vorliegenden elektrostatischen, latenten Ladungsbildes mittels eines Trocken- oder Flüssigtoners, die Fixierung des Toners, beispielsweise durch einen nachfolgenden Schmelzvorgang, und die Entfernung der unbetonerten Bereiche der photoleitfähigen Aufzeichnungsschicht mittels eines geeigneten Auswaschmittels. Die so erhaltene Form kann dann in bekannter Weise für den Offset-Druck noch weiter vorbereitet werden, z.B. durch eine Hydrophilierung und Gummierung der wasserführenden Oberfläche.

Das Entwickeln bzw. Auswaschen der bildmässig belichteten Aufzeichnungsmaterialien kann durch Sprühen, Waschen, Abreiben Bürsten usw. mit dem Entwicklerlösungsmittel erfolgen. Als Entwicklerlösungsmittel kommen dabei, je nach Art des eingesetzten polymeren Bindemittels, wässrige Medien, wie z.B. Wasser oder Mischungen von Wasser mit organischen Lösungsmitteln, wie beispielsweise Alkoholen, sowie insbesondere wässrigalkalische Lösungen in Betracht, die zur Einstellung des günstigsten pH-Wertes, im allgemeinen im Bereich von 8 bis 14, vorzugsweise im Bereich von 9 bis 12, alkalisch reagierende Substanzen, wie z.B. Borax, Dinatriumhydrogenphosphat, Soda oder Alkalihydroxide oder organische Basen, wie Di- oder Triethanolamin, enthalten.

Die wässrig-alkalischen Entwicklerlösungen können auch Puffersalze, z.B. wasserlösliche Alkaliphosphate, -silikate, -borate, -acetate oder -benzoate enthalten. Als weitere Bestandteile der Entwicklungslösungsmittel können Netzmittel, vorzugsweise anionische Netzmittel, und gegebenenfalls wasserlösliche Polymere, wie z.B. Natriumcarboxymethylcellulose, Polyvinylalkohol, Polynatriumacrylat und dergleichen, mitverwendet werden. Ferner ist es möglich, wenn die wässrig-alkalischen Entwicklerlösungsmittel auch Zusätze von wasserlöslichen, organischen Lösungsmitteln, wie z.B. aliphatischen Alkoholen, Aceton oder Tetrahydrofuran, enthalten.

Die erfindungsgemässen lichtempfindlichen Aufzeichnungsmaterielien zeichnen sich durch eine Kombination sehr guter Eigenschaften aus, insbesondere durch gute mechanische Eigenschaften und hohe Beständigkeit in der Anwendung bei gleichzeitig guten Belichtungseigenschaften und insbesondere kurzen Auswaschzeiten. Sie eignen sich daher mit Vorteil für alle Anwendungsgebiete in der Reprographie, wo leichte Auswaschbarkeit bei gleichzeitig hohem mechanischem Niveau erwünscht sind.

Die Erfindung wird durch die nachfolgenden Beispiele zusätzlich erläutert. Die in den Beispielen genannten Teile und Prozente beziehen sich, sofern nicht anders vermerkt, auf das Gewicht. Als Masszahl für das Molekulargewicht der Polymeren wurde der K-Wert nach Fikentscher (gemessen in 1%iger Lösung des jeweiligen Polymeren in Tetrahydrofuran) bestimmt.

*Beispiel 1*

Es wurde eine 5%ige Lösung in Tetrahydrofuran aus folgenden Komponenten hergestellt:

55 Teile eines Copolymerisats aus 52% Styrol, 20% Maleinsäureanhydrid, 27,6% Methacrylsäure und 0,4% Methacrylsäureanhydrid (hergestellt durch Fällungspolymerisation; K-Wert: 54,6; Erweichungsbereich: 240-245°C), 37 Teile 2-(4'-Diethylaminophenyl)-benztriazol-1,2,3 und 0,5 Teile Rhodamin 6 G (C.I. 45160).

Diese Lösung wurde in einer solchen Schichtdicke auf ein offset-typisches Aluminiumträgerblech aufgetragen, dass nach dem Ablüften des Lösungsmittels eine Trockenschichtdicke von 3,5 µm resultierte. Diese elektrophotographische Platte wurde elektrostatisch auf −600 V oberflächlich beladen, darauf bildmässig mit einer Beleuchtungsstärke von 8 µW cm$^{-2}$ in der Schichtebene 15 sec lang belichtet, und mit einem handelsüblichen Pulvertoner betont.

Nach der Tonerfixierung wurden die unbetonerten Bereiche der elektrophotografischen Schicht mit einem Gemisch aus 0,5% Soda, 25% Isopropanol und 74,5% Wasser abgewaschen, wodurch die Aluminiumoberfläche freigelegt wurde. Nach der Gummierung wurde diese Platte direkt in einer Offset-Maschine angedruckt. Es wurde eine einwandfreie Druckqualität erzielt, wobei auch nach langen Druckzeiten noch keine Abriebspuren zu erkennen waren.

*Beispeil 2*

Unter Einsatz von 14 Teilen eines Copolymerisats aus 43% Styrol, 28% Methylmethacrylat, 21% Acrylsäure, 7,6% 2-Hydroxypropylacrylat und 0,4% Methacrylsäureanhydrid (hergestellt durch Fällungspolymerisation; K-Wert: 54,3; Erweichungspunkt: ca 230°C), 8,75 Teilen Trimetylolpropantriacrylat, 1,5 Teilen Benzophenon, 0,5 Teilen Michlers Keton und 0,25 Teilen Kristallviolett (C.I. 42555) wurde eine 5%ige Lösung in Dimethoxymethan hergestellt. Diese Lösung wurde so auf ein offset-typisches Aluminiumträgerblech aufgegossen, dass nach dem Ablüften des Lösungsmittels eine Trockenschichtdicke von 1,8 µm resultierte. Nach dem Trocknen wurde diese Schicht noch mit einer 4,5 µm dicken Deckschicht aus hochverseiftem Polyvinylalkohol (Verseifungsgrad: 98 mol.%) versehen.

Das so hergestellte Aufzeichnungsmaterial wurde mit einem 5 kW-Halogenid-Hochdruckbrenner in 1 m Entfernung 5,5 sec lang durch ein Standard-Negativ bildmässig belichtet. Die belichtete Platte wurde dann mit einer wässrig-alkalischen Lösung mit einem pH-Wert von 11,6 in einem Durchlaufwascher in 25 sec ausgewaschen. Nach der Gummierung wurden mit der so erhaltenen Offset-Druckplatte in einer Offset-Druckmaschine ausgezeichnete Druckergebnisse ohne sichtbare Abnutzungserscheinungen erzielt.

*Beispiel 3*

Zur Herstellung eines Trockenfilmresistes wurde zunächst eine Lösung aus folgenden Bestandteilen hergestellt: 67 Teile eines Copolymerisats aus 48% Styrol, 19% Maleinsäureanhydrid, 32,6% Acrylsäure und 0,4% Methacrylsäureanhydrid (K-Wert: 53,5), 22 Teile Trimethylolpropantriacrylat, 11 Tetraethylenglykoldimethacrylat, 3 Teile Benzophenon, 0,3 Teilen Michlers Keton, 0,05 Teile Kristallviolett-Leukobase und 140 Teile Tetrahydrofuran. Diese Lösung wurde so auf eine 0,025 mm dicke Polyesterfolie gegossen, dass nach dem Trocknen an Luft eine Trockenschichtdicke von etwa 25 µm resultierte. Die getrocknete Schicht wurde anschliessend mit einer etwa 25 µm dicken Polyethylenfolie bedeckt.

Nach Abziehen der Polyethylendeckfolie wurde die photopolymersisierbare Schicht auf eine Kupferplatine, wie sie für die Herstellung von gedruckten Schaltungen gebräuchlich ist, bei 120°C unter Druck auflaminiert. Anschliessend wurde die photopolymerisierbare Scicht durch die Polyesterfolie hindurch unter Verwendung einer entsprechenden Photomaske mit dem Muster der Leiterbahnen einer gedruckten Schaltung bildmässig belichtet. Die Belichtung erfolgte mit einer 400 W/50 A-Quecksilberdampflampe in einem Abstand von 30 cm mit einer Belichtungsdauer von 45 sec. Anschliessend wurde die Polyethylenterephthalatfolie abgezogen und die unbelichteten Bereiche der Photopolymerschicht 3,5 min lang mit einer 2%igen wässrigen Sodalösung ausgewaschen. Es wurde ein vorlagengetreues Resistmuster mit gut ausgebildeten Kanten erhalten. Die freigelegten, nicht durch das Resistmuster abgedeckten Bereiche der Kupferplatine konnten mit einer Ferrichloridlösung ohne Probleme geätzt werden. Nach dem Ätzen, anschliessendem Spülen und Trocknen wurde die Resistschicht von dem verbliebenen Kupfer durch 2 min langes Eintauchen in eine 3%ige wässrige Natriumhydroxidlösung bei 70°C entfernt. Es resultierte eine Platte mit einer gedruckten Schaltung hoher Qualität.

**Patentansprüche**

1. Lichtempfindliches Aufzeichnungsmaterial, insbesondere für die Herstellung von Flachdruckplatten oder Resistmustern, mit einer ein in wässrigen Medien, insbesondere wässrig-alkalischen Medien, lösliches oder zumindest dispergierbares polymeres Bindemittel enthaltenden, wässrig entwickelbaren, lichtempfindlichen Aufzeichnungsschicht, dadurch gekennzeichnet, dass in der lichtempfindlichen Aufzeichnungsschicht als polymeres Bindemittel ein Copolymerisat enthalten ist, welches als Comonomeres ein Anhydrid einer polymerisierbaren, ethylenisch ungesättigten Monocarbonsäure in einer Menge von 0,05 bis 2 Gew.-%, bezogen auf das Copolymerisat, einpolymerisiert enthält.

2. Lichtempfindliches Aufzeichnungsmaterial nach Anspruch 1, dadurch gekennzeichnet, dass das Copolymerisat neben dem Anhydrid der polymerisierbaren, ethylenisch ungesättigten Monocarbonsäure als weitere Bestandteile mindestens 1 Comonomeres aus der Gruppe der vinylaromatischen Monomeren, Acrylsäureester und Methacrylsäureester und mindestens 1 Comonomeres aus der Gruppe Maleinsäureanhydrid, Maleinsäurehalbester, Acrylsäure und Methacrylsäure, sowie gegebenenfalls weitere andere Comonomere einpolymerisiert enthält.

3. Lichtempfindliches Aufzeichnungsmaterial gemäss Anspruch 2, dadurch gekennzeichnet, dass das Copolymerisat Styrol, Maleinsäureanhydrid, (Meth)arylsäureanhydrid sowie gegebenenfalls weitere Comonomeren einpolymerisiert enthält.

4. Lichtempfindliches Aufzeichnungsmaterial gemäss Anspruch 3, dadurch gekennzeichnet, dass das Copolymerisat Styrol, Maleinsäureanhydrid, (Meth)acrylsäure, (Meth)acrylsäureanhydrid sowie gegebenenfalls weitere Comonomeren einpolymerisiert enthält.

5. Lichtempfindliches Aufzeichnungsmaterial gemäss Anspruch 2, dadurch gekennzeichnet, dass das Copolymerisat (Meth)acrylsäureester, (Meth)acrylsäure, (Meth)acylsäureanhydrid sowie gegebenenfalls weitere Comonomeren einpolymerisiert enthält.

6. Lichtempfindliches Aufzeichnungsmaterial gemäss Anspruch 5, dadurch gekennzeichnet, dass das Copolymerisat Styrol, (Meth)acrylsäureester, (Meth)acrylsäure, (Meth)acrylsäureanhydrid sowie gegebenenfalls weitere Comonomeren einpolymerisiert enthält.

7. Lichtempfindliches Aufzeichnungsmaterial gemäss einem der Ansprüche 1 bis 6, dadurch gekennzeichnet, dass die lichtempfindliche Aufzeichnungsschicht photopolymerisierbar ist und neben dem polymeren Bindemittel mindestens eine photopolymerisierbare, ethylenisch ungesättigte, niedermolekulare Verbindung, mindestens einen Photoinitiator oder ein Photoinitiator-System sowie gegebenenfalls weitere Zusatz- und/oder Hilfsstoffe enthält.

8. Lichtempfindliches Aufzeichnungsmaterial gemäss einem der Ansprüche 1 bis 6, dadurch gekennzeichnet, dass es ein elektrophotographisches Aufzeichnungsmaterial mit einer lichtempfindlichen, photoleitfähigen Aufzeichnungsschicht ist, welche neben dem polymeren Bindemittel mindestens eine Ladungsträger transportierende Verbindung, mindestens eine Ladungsträger erzeugende Verbindung bzw. einen Sensibilisator sowie gegebenenfalls weitere übliche Zusatzstoffe enthält.

9. Lichtempfindliches Aufzeichnungsmaterial nach Anspruch 8, dadurch gekennzeichnet, dass in der photoleitfähigen Aufzeichnungsschicht als Ladungsträger transportierende Verbindung Triazol-Derivate oder Hydrazon-Derivate enthalten sind.

10. Lichtempfindliches Aufzeichnungsmaterial nach einem der Ansprüche 8 oder 9, dadurch gekennzeichnet, dass in der photoleitfähigen Aufzeichnungsschicht als Ladungsträger erzeugende Verbindung bzw. Sensibilisator Sensibilisierungsfarbstoffe enthalten sind.

**Claims**

1. A photosensitive recording material, in particular for the production of lithographic printing plates or resist images, comprising a photosensitive recording layer which can be developed with an aqueous medium, and contains a polymeric binder which is soluble or at least dispersible in an aqueous, in particular aqueous alkaline, medium, wherein the polymeric binder contained in the photosensitive recording layer is a copolymer which contains, a a copolymerized comonomer, an anhydride of a polymerizable, ethylenically unsaturated monocarboxylic acid in an amount of from 0.05 to 2% by weight, based on the copolymer.

2. A photosensitive recording material as claimed in claim 1, wherein the copolymer contains as further components — in addition to the anhydride of the polymerizable, ethylenically unsaturated monocarboxylic acid — one or more comonomers from the group consisting of vinylaromatic monomers, acrylates and methacrylates, and one or more comonomers from the group consisting of maleic anhydride, maleic half esters, acrylic acid and methacrylic acid, and, if desired, other comonomers as copolymerized units.

3. A photosensitive recording material as claimed in claim 2, wherein the copolymer contains, as copolymerized units, styrene, maleic anhydride, (meth)acrylic anhydride and, if desired, further comonomers.

4. A photosensitive recording material as claimed in claim 3, wherein the copolymer contains, as copolymerized units, styrene, maleic anhydride, (meth)acrylic acid, (meth)acrylic anhydride and, if desired, further comonomers.

5. A photosensitive recording material as claimed in claim 2, wherein the copolymer contains, as copolymerized units, (meth)acrylates, (meth)acrylic acid, (meth)acrylic anhydride and, if desired, further comonomers.

6. A photosensitive recording material as claimed in claim 5, wherein the copolymer contains, as copolymerized units, styrene, (meth)acrylates, (meth)acrylic acid, (meth)acrylic anhydride and, if desired, further comonomers.

7. A photosensitive recording material as claimed in any of claims 1 to 6, wherein the photosensitive recording layer is photopolymerizable and contains, in addition to the polymeric binder, one or more photopolymerizable, ethylenically unsaturated, low molecular weight compounds, one or more photoinitiators or a photoinitiator system and, if desired, further additives and/or assistants.

8. A photosensitive recording material as claimed in any of claims 1 to 6 in the form of an electrophotographic recording material comprising a photosensitive, photoconductive recording layer which contains, in addition to the polymeric binder, one or more charge carrier-transporting compounds, one or more charge carrier-producing compounds or sensitizers and, if desired, further conventional additives.

9. A photosensitive recording material as claimed in claim 8, wherein the photoconductive recording layer contains, as charge carrier-transporting compounds, triazole derivatives or hydrazone derivatives.

10. A photosensitive recording material as claimed in claim 8 or 9, wherein the photoconductive recording layer contains sensitizing dyes as charge carrier-producing compounds or sensitizers.

**Revendications**

1. Matière d'enregistrement sensible à la lumière, en particulier pour la fabrication de plaques d'impression planographique ou modèles réserves, comportant une couche d'enregistrement sensible à la lumière, développable à l'eau, contenant un liant polymère, soluble, ou au moins dispersable dans des milieux aqueux, en particulier alcalino-aqueux, caractérisée par le fait que, dans la couche d'enregistrement sensible à la lumière, est contenu un copolymérisat qui contient, comme comonomère, un anhydride d'un acide monocarboxylique insaturé éthyléniquement et polymérisable, en proportion de 0,05 à 2% en poids, par rapport au copolymérisat.

2. Matière d'enregistrement sensible à la lumière selon la revendication 1, caractérisée par le fait que le copolymérisat contient, en polymérisation, outre l'anhydride d'un acide monocarboxylique insaturé éthyléniquement et polymérisable, comme autre constituant, au moins 1 comonomère du groupe des monomères vinylaromatiques, esters d'acide acrylique et esters d'acide méthacrylique, et au moins 1 comonomère du groupe anhydride d'acide maléique, semi-esters d'acide maléique, acide acrylique et acide méthacrylique, ainsi qu'éventuellement encore d'autres comonomères.

3. Matière d'enregistrement sensible à la lumière selon la revendication 2, caractérisée par le fait que le copolymérisat contient, en polymérisation, du styrène, de l'anhydride d'acide maléique, de l'anhydride d'acide (méth)acrylique ainsi qu'éventuellement d'autres comonomères.

4. Matière d'enregistrement sensible à la lumière selon la revendication 3, caractérisée par le fait que le copolymérisat contient, en polymérisation, du styrène, de l'anhydride d'acide maléique, de l'acide-(méth)acrylique, de l'anhydride d'acide (méth)acrylique, ainsi qu'éventuellement d'autres comonomères.

5. Matière d'enregistrement sensible à la lumière selon la revendication 2, caractérisée par le fait que le copolymérisat contient, en polymérisation, de l'ester d'acide (méth)acrylique, de l'acide (méth)arcylique, de l'anhydride d'acide (méth)acrylique, ainsi qu'éventuellement d'autres comonomères.

6. Matière d'enregistrement sensible à la lumière selon la revendication 5, caractérisée par le fait que le copolymérisat contient, en polymérisation, du styrène, de l'ester d'acide (méth)acrylique, de l'acide (méth)acrylique, de l'anhydride d'acide (méth)acrylique, ainsi qu'éventuellement d'autres comonomères.

7. Matière d'enregistrement sensible à la lumière selon l'une des revendications 1 à 6, caractérisée par le fait que la couche d'enregistrement sensible à la lumière est photopolymérisable et contient, outre le liant polymère, au moins un composé à bas poids moléculaire, insaturé éthyléniquement, photopolymérisable, au moins un photoinitiateur, ou un système photoinitiateur ainsi qu'éventuellement d'autres additifs et/ou auxiliaires.

8. Matière d'enregistrement sensible à la lumière selon l'une des revendications 1 à 6, caractérisée par le fait que c'est une matière d'enregistrement électrophotographique à couche d'enregistrement photoconductrice, sensible à la lumière qui, outre le liant polymère, contient au moins un composé transportant des porteurs de charge, au moins un composé créant des porteurs de charge ou un sensibilisateur, ainsi qu'éventuellement d'autres additifs usuels.

9. Matière d'enregistrement sensible à la lumière selon la revendication 8, caractérisée par le fait que, dans la couche d'enregistrement photoconductrice, sont contenus, comme composés transportant les porteurs de charge, des dérivés de triazole ou des dérivés d'hydrazone.

10. Matière d'enregistrement sensible à la lumière selon l'une des revendications 8 ou 9, caractérisée par le fait que, dans la couche d'enregistrement photoconductrice, sont contenus, comme composés générant des porteurs de charge ou sensibilisateurs, des colorants sensibilisateurs.